Europäisches Patentamt

European Patent Office

Office européen des brevets

(19)

(11) **EP 1 146 647 B1**

(12) **FASCICULE DE BREVET EUROPEEN**

(45) Date de publication et mention
de la délivrance du brevet:
**10.08.2005 Bulletin 2005/32**

(51) Int Cl.⁷: **H03L 7/197**, H03L 7/093

(21) Numéro de dépôt: **01400852.8**

(22) Date de dépôt: **03.04.2001**

(54) **Synthétiseur fractionnaire comportant une compensation de la gigue de phase**

Synthetisierer mit gebrochenem Teilverhältnis und Kompensation des Phasenjitters

Fractional-N synthesizer with phase jitter compensation

(84) Etats contractants désignés:
**AT BE CH CY DE DK ES FI FR GB GR IE IT LI LU MC NL PT SE TR**

(30) Priorité: **11.04.2000 FR 0004644**

(43) Date de publication de la demande:
**17.10.2001 Bulletin 2001/42**

(73) Titulaire: **Thales**
**75008 Paris (FR)**

(72) Inventeurs:
• **Dinh, Huu-Thinh,**
**c/o Thomson-CSF Proprieté Intell.**
**94117 Arcueil Cédex (FR)**

• **Peris, Daniel,**
**c/o Thomson-CSF Proprieté Intellec.**
**94117 Arcueil Cédex (FR)**
• **Nadal, Ghyslain,**
**c/o Thomson-CSF Proprieté Intell.**
**94117 Arcueil Cédex (FR)**

(74) Mandataire: **Dudouit, Isabelle**
**THALES Intellectual Property,**
**31-33 avenue Aristide Briand**
**94117 Arcueil Cedex (FR)**

(56) Documents cités:
EP-A- 0 147 307          WO-A-99/33181
US-A- 5 818 303

**Description**

La présente invention concerne un synthétiseur à temps d'acquisition rapide et à faible bruit de phase utilisant le principe de la division fractionnaire en mettant en oeuvre une technique de compensation de la gigue de phase adaptée à un fonctionnement basse tension et à une puissance consommée minimale.

Elle concerne, par exemple, les synthétiseurs fonctionnant sous une tension basse et unique de 2,7 V et est compatible avec une technologie et une intégration ASIC, ceci toujours pour une puissance consommée minimale.

Avantageusement de tels synthétiseurs permettent d'atteindre une canalisation compatible avec des équipements radiotéléphones notamment respectant la norme GSM ou GPRS.

L'invention trouve aussi son application dans tout dispositif intégrant une synthèse de fréquence avec la contrainte d'une alimentation en basse tension et en puissance minimale.

L'art antérieur divulgue des synthétiseurs de fréquence ayant des temps d'acquisition de fréquence très brefs et de très bonnes résolutions en fréquence. Le synthétiseur développé par Philips sous la référence catalogue SA 8025 en est un exemple.

Toutefois, les fréquences de comparaison habituellement utilisées ne sont en général pas compatibles avec les caractéristiques spectrales demandées et ne permettent pas d'obtenir le temps d'acquisition voulu dans le cadre d'applications ayant un fonctionnement faible tension et une puissance minimale.

Il a été démontré que dans la synthèse à division fractionnaire, l'écart de l'erreur de phase au niveau du comparateur de phase est proportionnel :

- à la valeur Pk (erreur de phase dynamique) contenue dans l'accumulateur de phase, et
- à la période Ts=1/Fs du signal synthétisé Fs.

La valeur Pk est variable et connue à chaque période de référence Tr ainsi que Fs. Si Fr est la fréquence de référence il suffit donc d'élaborer à chaque période de référence 1/Fr, un signal proportionnel à tout instant à ces deux grandeurs afin d'assurer une compensation de cette erreur de phase. L'erreur de phase étant différente à chaque cycle de référence, la durée de correction doit être sensiblement inférieure à 1/Fr.

Différentes solutions ont été proposées pour minimiser voire supprimer les raies de gigue de phase dues à la synthèse fractionnaire. Une des solutions consiste à rèaliser une correction à poids de courant modulés en durée ( le signal de compensation Ic a à la fois une intensité et une durée qui sont fonction de la valeur fournie par un accumulateur de phase) telle que décrite dans le brevet FR 2.557.401 du demandeur. Le synthétiseur à division fractionnaire et à faible gigue de phase décrit dans ce brevet comporte plusieurs sources de courant qui sont sommées en tenant compte de la température et de la linéarité avant d'être envoyées vers un intégrateur. Le synthétiseur comporte un amplificateur opérationnel alimenté avec deux tensions élevées, une positive et une négative et un circuit convertisseur Numérique-Analogique ou CNA commandant les sources de courant. La tension d'asservissament est échantillonnée par un circuit échantillonneur-bloqueur avant d'être envoyée sur la commande de l'oscillateur. Un tel dispositif, bien que permettant de diminuer la gigue de phase, ne peut s'appliquer aux applications rapides et à faible consommation, notamment les applications basse tension (unique ou non) telle que le GSM.

Il s'avère aussi difficile d'assurer une tension nulle au noeud de sommation des différentes sources de courant et ce quelles que soient la tension de commande de l'oscillateur et la température dissipée dans le circuit. En effet, lorsque la tension de commande de l'oscillateur varie, la tension au noeud de sommation des sources de courants varie aussi à cause de l'imprécision du prépositionnement. Il en résulte une modification du point de fonctionnement de l'amplificateur d'asservissement qui entraine alors une modification du courant de correction.

Le brevet US 5 818 303 concerne un synthétiseur fractionnaire dans lequel la fréquence de division d'un synthétiseur à boucle de phase ou PLL varie de façon périodique et un circuit permettant d'annuler les signaux parasites.

La présente invention propose une façon simple et efficace pour réaliser la compensation de la gigue de phase due à la synthèse fractionnaire.

L'invention concerne un synthétiseur de fréquence à division fractionnaire multiple comportant un générateur de fréquence, un oscillateur commandé en tension, un diviseur programmable à rang variable N, un comparateur de phase, un circuit d'intégration et de filtre, un générateur de fenêtre temporelle, une source de courants pondérés, un accumulateur de phase, un circuit charge-pompe comportant plusieurs transistors.

Il est caractérisé en ce que ladite source de courants pondérés est reliée audit circuit charge-pompe de manière à commuter directement les courants l'émetteur d'un ou de plusieurs transistors du circuit charge-pompe, la source de courants pondérés est commandée par un signal généré par le générateur de fenêtre temporelle pendant une durée $\Delta$Tcor.

Le synthétiseur est par exemple alimenté sous une faible tension sensiblement égale à 2,7 V.

Le circuit charge-pompe peut comporter au moins :

- un transistor (Q3) ayant un émetteur relié à une résistance Rc en liaison elle-même au comparateur de phase,
- un transistor (Q2) dans lequel circule un courant de charge Ic, en liaison avec le circuit d'intégration et
- un transistor (Q4) ayant un émetteur relié à une résistance Rp reliée au comparateur de phase et un collecteur relié au circuit d'intégration un courant Ip de décharge circulant à travers la résistance Rp et le transistor Q4,

et en ce que la source de courant de poids pondérés comporte une ou plusieurs résistances R1, R2, R3 disposées en parallèle, la ou lesdites résistances étant reliées à l'émetteur du transistor Q3 et à au moins un transistor à effet de champ Q5, Q6, Q7 recevant au niveau de chacune de leur grille une ou les valeurs de Pk contenues dans l'accumulateur de phase, la source des transistors à effet de champ étant en liaison avec le générateur de fenêtre temporelle de correction générant pendant un temps de correction Tcor un niveau bas ou « 0V ».

Selon un autre mode de réalisation le circuit charge-pompe comporte par exemple ;

- un transistor Q3 dont l'émetteur est relié à une résistance Rc en liaison elle-même avec le comparateur de phase,

- un transistor Q2 dans lequel circule le courant de charge Ic en liaison avec le circuit d'intégration et

- un transistor Q4 dont l'émetteur est relié à une résistance Rp en liaison avec le comparateur de phase et le collecteur en liaison avec la circuit d'intégration, le courant Ip de décharge circultant à travers Rp et un transistor Qr dont la base est reliée à la base de l'èmetteur Q3, le collecteur reliè à la base de Q1 et l'émetteur est relié à une résistance Rcor, la résistance Rcor étant reliée à dispositif générant un signal de niveau bas « 0V » pendant une durée de

L'invention concerne aussi un synthétiseur de fréquence à temps d'acquisition rapide et à faible bruit de phase à division fractionnaire comportant au moins une des caractéristiques données ci-dessus.

L'invention concerne aussi un dispositif de radiocommunication comportant au moins un émetteur et un récepteur et un synthétiseur de fréquence à division fractionnaire comportant au moins une des caractéristiques précédentes.

L'invention concerne aussi un procédé pour synthétiser une fréquence comportant au moins les étapes suivantes :

- coupler une sortie de la source de courants pondérés au circuit de charge-pompe afin de commuter directement un ou plusieurs courants de correction sur un émetteur d'au moins un des transistors du circuit de charge-pompe, et
- générer un signal à partir du générateur de fenêtre temporelle de niveau bas « 0 » et appliquer ce signal à la source de courants pondérés pendant une durée ∆Tcor.

Le procédé et le dispositif selon l'invention s'appliquent par exemple dans le domaine du GSM et/ou du GPRS.

Le synthétiseur selon l'invention présente notamment les avantages suivents

- il améliore d'au moins 10 dB le bruit de phase dans la bande passente du synthétiseur pour une technologie constante, par exemple la technologie ASIC.
- il permet de dégrader le moins possible le bruit de phase délivré à la sortie de la fonction charge pompe.
- il conserve son efficacité sur toute la plage de fréquence synthétisée.
- il offre la possibilité de n'utiliser qu'une seule tension d'alimentation qui peut descendre jusqu'à 2,7 V.

D'autres caractéristiques et avantages de l'invention apparaltront à l'aide de la description qui va suivre faite à titre illustratif et nullement limitatif en regard des figures annexées qui représentent :

- la figure 1 est un schéma d'une boucle de synthétiseur.
- la figure 2 est un schéma synoptique de l'agencement du circuit charge-pompe et source de courants inclus dans le synthétiseur selon l'invention,
- la figure 3 représente un premier exemple de synthétiseur selon l'invention, et
- la figure 4 schématise un deuxième exemple de mise en oeuvre de l'invention.

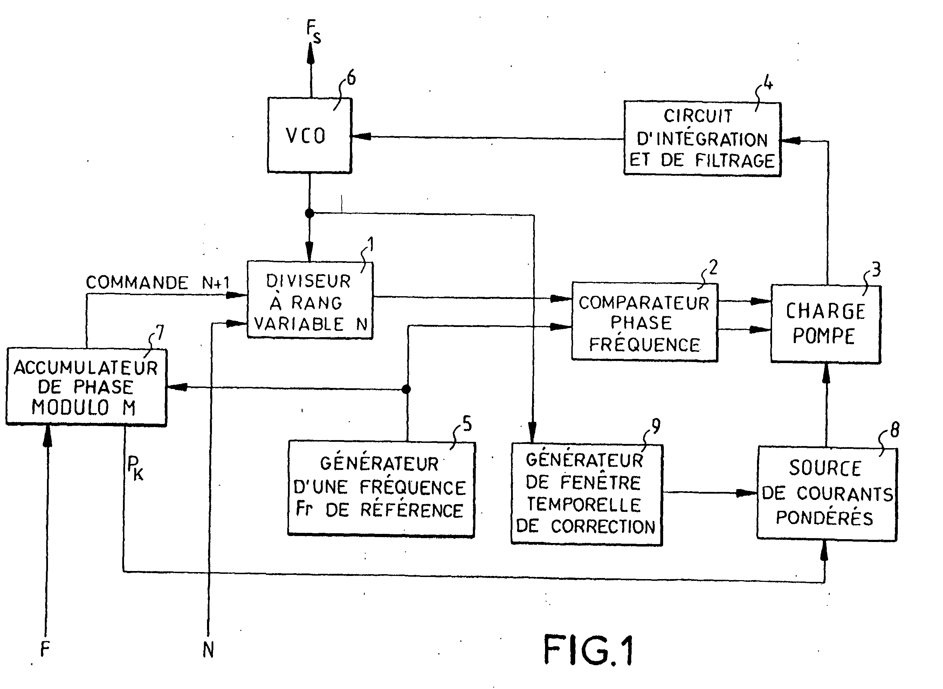

La figure 1 représente un synthétiseur classique comportant un diviseur 1 à rang variable N, suivi d'un comparateur phase-fréquence 2, lui-même suivi d'un étage ou circuit charge-pompe 3, un circuit d'intégration et de filtrage 4, un oscillateur 6 contrôlé en tension habituellement désigné par l'abréviation anglaise VCO (Voltage Control Oscillator).

Il comporte aussi un générateur 5 de fréquence de référence Fr couplé d'une part au comparateur phase-fréquence 2 et d'autre part à un accumulateur de phase 7 modulo M permettant d'obtenir le pas fractionnaire.

Un circuit 8 de source de courants pondérés couplé à un générateur 9 de fenêtre temporelle de correction permet d'effectuer la correction de gigue de phase.

La fonction des différents éléments constituant le synthétiseur est rappelée brièvement car elle est connue de l'Homme du métier.

L'oscillateur asservi 6 fournit un signal de fréquence Fs à une entrée du diviseur 1 de rang N et à une sortie du synthétiseur.

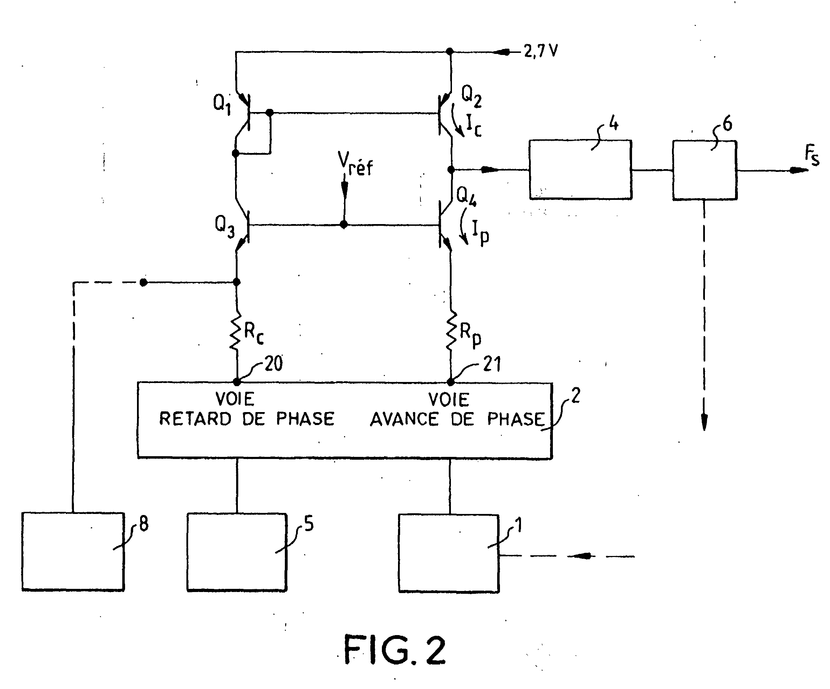

Le diviseur 1 possède une sortie fournissant un signal de référence Fs/N au comparateur fréquence-phase 2. Ce comparateur 2 reçoit aussi le signal de référence Fr fourni par le générateur de fréquence 5. Il possède deux sorties appelées voie de retard et voie d'avance (figures 2, 3, 4) en liaison avec le circuit charge-pompe 3.

Le circuit charge-pompe 3 est relié à la source de courants pondérés 8 et possède une sortie vers un circuit d'intégration et de filtrage 4 connu de l'homme du métier. Ce circuit intégrateur réalise une intégration en fonction des charges apportées par les courants Ic de charge et Ip de décharge et fournit une tension V filtrée avant d'être appliquée au VCO.

Le générateur de fenêtre temporelle 9 reçoit sur une entrée la fréquence synthétisée Fs issue de l'oscillateur VCO et fournit à la source de courants pondérés 8 un créneau temporel $\Delta$Tcor correspondant à la durée pendant laquelle la correction doit être réalisée.

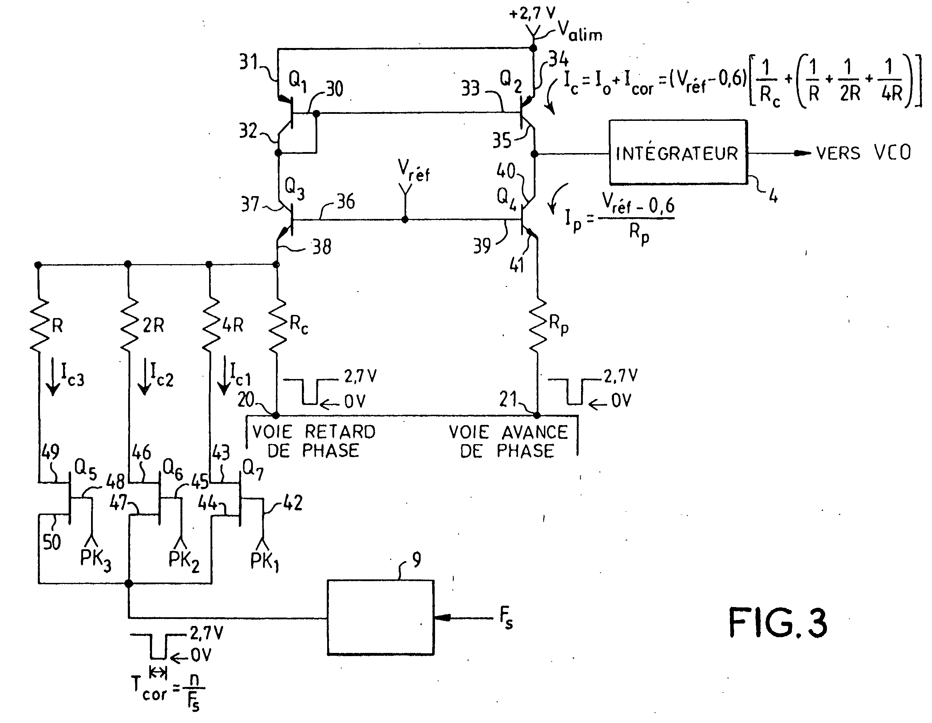

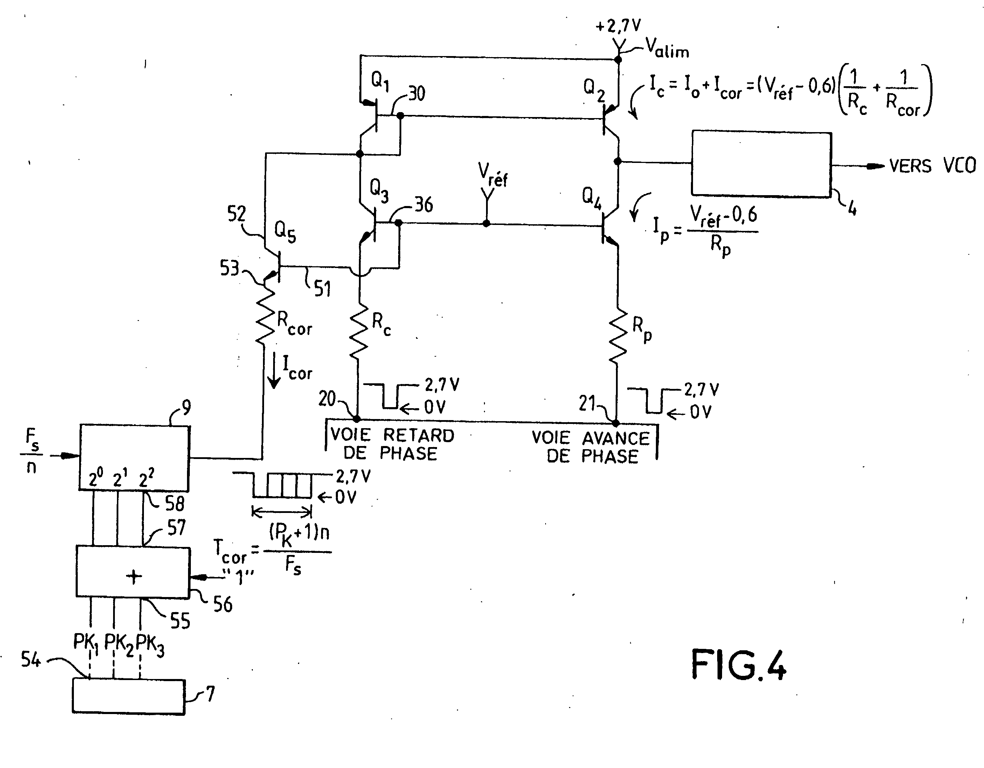

L'accumulateur de phase 7 accumule la valeur k*M à une fréquence Fr et fournit la valeur cumulée Pk à la source de courants pondérés 8 dont le fonctionnement et deux exemples de mise en oeuvre sont détaillés aux figures 3 et 4.

Principe de la division fractionnaire

Le rang de division prend séquentiellement, selon une loi calculée en temps réel, une des valeurs N ou N+1, pour que le pas de synthèse soit un pas fractionnaire sous-multiple de la fréquence de référence Fr appliquée sur une entrée du comparateur de phase.

La fréquence synthétisée à la sortie de l'oscillateur 6 est obtenue par une moyenne sur M cycles de la fréquence de référence Fr durant lesquelles la division est effectuée F fois par la valeur N+1 et M-F fois par la valeur N.

L'expression de Fs s'écrit alors :

$$Fs = \left[\frac{(F(N+1)) + (M-F)N}{M}\right]Fr$$

Ou encore (1)

$$Fs = \left[N + \frac{F}{M}\right]Fr$$

Avec N le rang de division entier et F/M la partie fractionnaire de la division, F étant un nombre entier tel que

$$0 \le F\langle M$$

Le plus petit incrément de fréquence est obtenu en modifiant F d'une unité et représente le pas P du synthétiseur. Ce pas est ici égal à Fr/M au lieu d'être égal à Fr pour une synthèse de fréquence classique.

Le fait de synthétiser les pas fractionnaires ou multiples de la quantité Fr/M introduit une erreur de phase dynamique Pk à chaque cycle de référence qui se traduit par une modulation de phase importante du signal de l'oscillateur contrôlé en tension. Cette erreur de phase est classiquement générée et totalisée au moyen de l'accumulateur de phase 7 dont le contenu est incrémenté de la valeur F à chaque comparaison effectuée par le comparateur 2.

Le contenu Pk de l'accumulateur permet ainsi de connaître l'écart temporel de phase, $\Delta$Tk, qui existe à tout instant k, entre le signal de boucle et le signal de référence, cet écart $\Delta$Tk étant défini par la relation :

$$\Delta Tk = Pk/(M*Fs) \tag{2}$$

Comme le contenu Pk de l'accumulateur est constamment variable, la relation (2) montre qu'il existe toujours une modulation en position du front montant du signal de boucle Fb au cours du temps et cette position est toujours en avance de phase par rapport au front montant du signal de référence Fr car le signal de boucle est obtenu en réalité par une division N au lieu de N+F/M comme l'indique la relation (1). Le comparateur de phase 2 va donc générer sur la voie avance de phase un signal qui évolue au cours du temps et qui commande la décharge de la capacité de l'intégration de la boucle (circuit intégrateur). C'est cette perte de charge qui crée les raies parasites sur la fréquence synthétisée.

L'idée de l'invention consiste à utiliser l'erreur de phase Pk contenue dans l'accumulateur de phase pour injecter un courant de charge lc permettant de compenser la perte de charge due à la division fractionnaire. La charge ou la décharge de l'intégrateur se fait par un courant constant référencé à une tension de référence stable. Le courant de compensation est issu du courant de charge lc. La tension d'asservissement V issue de l'intégrateur 4 est envoyée directement sur la commande de l'oscillateur VCO et les commandes des différentes sources de courants 8 sont activées par des signaux numériques délivrés par l'accumulateur de phase 7, sans interface.

La tension de commande ou tension d'asservissement appliquée sur l'oscillateur 6 reste alors constante ce qui donne un spectre en fréquence pur en sortie de la boucle ou du synthétiseur.

Le synthétiseur selon l'invention comporte les éléments décrits à la figure 1 où le circuit charge-pompe 3 et le circuit de source de courant de compensation 8 couplé au générateur de fenêtre temporelle de correction 9, sont reliés directement selon un schéma décrit à la figure 2 et aux figures 3 et 4. L'ensemble est alimenté sous une tension unique de 2,7 V considérée comme une basse tension.

Un tel agencement entre les différents éléments du synthétiseur permet notamment de convertir la gigue de phase détectée par le comparateur de phase 2 entre le signal de boucle et le signal de référence en tension pour asservir la fréquence synthétisée.

En présence de la partie fractionnaire, le système de la compensation de la gigue de phase est mis en route automatiquement, les valeurs de Pk n'étant pas nulles et venant modifier directement le courant de charge de la capacité de l'intégration de la boucle.

Le circuit charge-pompe 3 dans cet exemple de réalisation comporte quatre transistors Q1, Q2, Q3 et Q4 disposés par exemple selon le schéma de la figure 2. Les émetteurs 31, 33 des transistors Q1 et Q2 sont en liaison avec la source d'alimentation Valim 2,7 V. Leurs collecteurs 32, 35 sont reliés respectivement aux collecteurs 37, 40 des transistors Q3 et Q4. La base 30 de Q1 est reliée à la base 33 de Q2; les bases 36, 40 des transistors Q3 et Q4 sont reliées et polarisées à une tension de référence Vréf. L'émetteur 38 du transistor Q3 est relié par l'intermédiaire d'une résistance Rc au comparateur de phase 2 et l'émetteur 41 du transistor Q4 est relié via une résistance Rp au comparateur de phase 2.

L'émetteur 38 du transistor Q3 est aussi en liaison directe avec le circuit générateur de courant 8 dont l'architecture est par exemple décrite aux figures 3 et 4.

Le circuit charge-pompe 3 fonctionne par exemple de la manière suivante :

Le signal de boucle Fb issu du diviseur à rang variable 1 et le signal de référence Fr issu du générateur de fréquence 5 sont transmis au comparateur de phase fréquence 2.
Trois cas peuvent être envisagés :

1) Lorsque ces deux signaux Fb et Fr sont en phase, la sortie 20 retard de phase et la sortie 21 avance de phase du comparateur de phase sont à niveau logique « 1 » c'est-à-dire à une valeur de tension égale à la tension d'alimentation, dans notre exemple à 2,7 V. Les transistors Q3 et Q4 sont bloqués. Le courant de charge Ic circulant dans le transistor Q2 et le circuit intégrateur et le courant de décharge Ip circulant à travers l'intégrateur, le transistor Q4 et la résistance Rp sont nuls ou sensiblement nuls. La valeur de tension aux bornes de la capacité du circuit d'intégration est donc constante ou sensiblement constante.

2) Dans le cas où le signal de boucle Fb est en retard par rapport au signal de référence Fr, la fréquence de l'oscillateur 6 (VCO) étant plus basse que la fréquence désirée, le comparateur de phase va générer un niveau logique « 0 » sur la voie retard de phase 20 . La résistance Rc est alors reliée à la masse via le comparateur de phase 2 sur cette voie. Un courant de charge Ic sensiblement égal à (Vréf-0.6)/Rc circule dans cette résistance Rc et par effet de miroir du courant, un courant d'une valeur sensiblement égale circule dans le collecteur du transistor Q2 afin de charger la capacité du circuit d'intégration. L'augmentation de la tension de l'intégrateur prise par exemple, en sortie d'intégrateur de circuit d'intégration, entraîne une augmentation de la fréquence de l'oscillateur 6, ceci jusqu'à ce que la fréquence désirée soit atteinte.

3) Dans le cas où le signal de boucle Fb est en avance de phase, c'est la voie 21 avance de phase qui va activer la décharge afin de diminuer la fréquence de l'oscillateur jusqu'à atteindre l'équilibre. Le comparateur de phase génère un niveau logique à 0 sur la voie d'avance de phase, la résistance Rp est reliée à la masse via le comparateur de phase 2 et un courant de décharge Ip circule à travers Q4 et la résistance Rp pour décharger la capacité du circuit intégrateur.

En présence de la partie fractionnaire Fr/M, la voie avance de phase active toujours une petite décharge due à la division fractionnaire à chaque coup d'horloge de référence. Cette perte de charge qui est la cause des raies parasites sur la fréquence synthétisée doit donc être annulée. Le procédé selon l'invention réalise cette annulation par injection d'une charge équivalente, selon deux variantes de réalisation explicitées ci-après en relation aux figures 3 et 4 principalement.

Première variante de réalisation - figure 3

L'injection de courants pondérés est réalisée pendant une durée de temps constante ou sensiblement constante.

Le circuit de courants pondérés 8 couplé au générateur de fenêtre temporelle de correction 9 permet d'appliquer une correction de courant pendant un temps qui est proportionnel à la période Ts = 1/Fs du signal synthétisé.

Dans cet exemple de réalisation, le circuit de courants pondérés comporte trois résistances R1=4R, R2=2R et R3=R, par exemple qui sont disposées en parallèle. Chacune de ces résistances est en liaison d'une part avec l'émetteur 38 du transistor Q3 et d'autre part avec un transistor à effet de champ référencé respectivement Q7, Q6 et Q5. L'accumulateur de phase 7 applique au niveau des grilles 42, 45, 48 de chacun des transistors Q7, Q6, Q5 la valeur de l'erreur de phase dynamique Pk1, Pk2, Pk3. Leur source 44, 47, 50 est polarisée à un potentiel délivré par le générateur de fenêtre temporelle 9 qui est un compteur n par exemple recevant la fréquence synthétisée Fs (Fs joue le rôle d'horloge pour le compteur), le drain 43, 46, 49 de ces transistors étant alimenté par les différents courants Ic1, Ic2 et Ic3 circulant les R1, R2, R3.

En présence de la partie fractionnaire, les valeurs de Pk données par l'accumulateur de phase 7 modulo M ne sont pas nuls. En fonction de sa valeur Pk relie ou non les résistances R1, R2 et R3 à la masse via le compteur 9 ou compteur n afin de faire circuler par effet de miroir de courant, un courant de correction Icor vers l'intégrateur 4 avec Ic=$I_0$+Icor. Icor est le courant généré automatiquement lors de la correction. $I_o$ est un courant qui circule lorsque le signal de boucle $F_o$ est en retard par rapport au signal de référence Fr.

Ce compteur n envoie un créneau dont l'état bas correspond à « 0 V » ou niveau bas et l'état haut à 2,7 V. La durée de l'état bas, Tcor, pendant laquelle le courant de correction va circuler est sensiblement égale ou égale à Tcor = n/Fs. Cette manière de procéder permet de réaliser une multiplication entre un courant et un temps, ce qui donne une quantité de charge Qcor à fournir à l'intégrateur 4, définie par Qcor = Icor*Tcor.
Ou encore (3)

$$Qcor = (Vref - 0,6)\left[\left(\frac{Pk3}{R} + \frac{Pk2}{2R} + \frac{Pk1}{4R}\right)\frac{C}{Fs}\right]$$

Avec Pk1 ; Pk2 ; Pk3 égal à »0 » ou « 1 » et C une constante choisie en fonction de la technologie du compteur.

Calcul de la quantité d'énergie perdue

Sachant qu'à chaque instant k, la quantité d'énergie perdue Qk est égale à (4)

$$Qk = \left[\left(\frac{Pk}{MFs}\right)Ip\right]$$

Avec Ip le courant de décharge du circuit charge pompe 3, Pk la valeur de l'erreur de phase à l'instant k, M la valeur du modulo de l'accumulateur.
Pour annuler cette perte de charge, le circuit de courants pondérés 8 injecte automatiquement un certain courant Icor = Ic1 + Ic2 + Ic3 pour charger la capacité d'intégration de la boucle (capacité du circuit intégrateur décrit en détail à la figure 4).

La somme des courants injectés est proportionnelle à la valeur Pk contenue dans l'accumulateur de phase et la durée de charge est proportionnelle à n fois la période Ts du signal synthétisé.

L'équilibre s'établit lorsqu'il y a égalité entre la quantité de charge à compenser donnée par la relation (3) et la quantité d'énergie perdue exprimée à la relation (4). Cet équilibre conduit à une valeur élémentaire le pour le courant de charge égale à Ip/(C*M), c'est-à-dire le = Ic1 dans cet exemple d'application.

Dans le cas d'un synthétiseur rapide couvrant la gamme de fréquence 3420 à 3840 MHz par exemple au pas de 400 KHz destiné notamment aux terminaux GSM/GPRS, la fréquence de référence Fr est choisie par exemple à 2 MHz, ce qui impose une valeur du modulo M égale à 5. Pk peut prendre les valeurs suivantes : 0, 1, 2, 3 et 4.

Pour Pk=0, l'erreur de phase est nulle.

Pour Pk=1, la gigue temporelle élémentaire de phase varie de 52 ps à 58,4 pico secondes selon la fréquence synthétisée.

Dans cet exemple d'application, la fenêtre de correction Tcor est prise par exemple égale à 40 fois la période Ts de la fréquence synthétisée, ce qui donne une valeur élémentaire pour le courant de charge le égale à Ip/(5*40). Comme Pk est une valeur binaire de 3 bits, il faut donc trois sources de courants de poids binaire respectivement Ic1=le, Ic2=2'le et Ic3=4*le.

Ainsi, la commutation des courants est la suivante

| Contenu de l'accumulateur de phase | Courant commuté pour la décharge de l'intégrateur |
|---|---|
| Pk=1 | Ic1 |
| Pk=2 | Ic2 |
| Pk=3 | Ic1 et Ic2 |
| Pk=4 | Ic3 |

La figure 4 décrit un autre mode de réalisation d'injection du courant constant à durée variable.

Le circuit charge pompe 3 comporte en plus des éléments décrits à la figure 3, un transistor Q5 dont la base 51 est reliée à la base 36 du transistor Q3, le collecteur 52 est en liaison avec la base 30 du transistor Q1 et l'émetteur 53 est relié à la résistance Rcor.

Le circuit de courants pondérés comporte une résistance Rcor reliée d'une part à l'émetteur 53 du transistor Q5 et d'autre part au compteur 9.

Cette autre façon de procéder fait appel à une source unique de courant de correction.

Son principe de fonctionnement est le suivant : le courant de correction Icor est activé par une simple mise à la masse de la résistance Rcor par le compteur 30 dont la durée Tcor à l'état bas « 0V » est égale à (Pk+1)*n/Fs, pour chaque cycle de référence, avec Pk qui correspond à la valeur des erreurs de phase contenues dans l'accumulateur de phase.

La charge correspondante est égale à Qcor = Icor*((Pk+1)*n/Fs) ou encore (5)

$$Qcor = \frac{Icor * Pk * n}{Fs} + \frac{Icor * n}{Fs}$$

La relation (5) montre qu'à une constante Icor*n/Fs près, la quantité de charge apportée est identique ou sensiblement identique à la quantité de charge perdue Qk de la relation (4) lorsque Icor=Ip/(n*M).

Les courants Ip et Ic circulent vers l'intégrateur ou à partir de l'intégrateur selon un principe identique à celui décrit à la figure 3.

Sans sortir du cadre de l'invention, le synthétiseur décrit aux figures 2 à 4 s'applique dans tout dispositif alimenté en basse tension, qu'elle soit issue d'une source unique ou de plusieurs sources et pour lequel la puissance de consommation doit être minimisée.

Elle s'applique en particulier dans des dispositifs de radiocommunications comportant un émetteur et un récepteur et un synthétiseur de fréquence selon la norme GSM/GPRS.

**Revendications**

**1.** Synthétiseur de fréquence à division fractionnaire multiple comportant un générateur de fréquence (5), un oscillateur commandé en tension (6), un diviseur (1) programmable à rang variable N, un comparateur de phase (2), un circuit d'intégration et de filtre (4), un générateur de fenêtre temporelle (9), une source de courants pondérés (8), un accumulateur de phase (7), un circuit charge-pompe (3) comportant plusieurs transistors (Qi) **caractérisé en ce que** ladite source de courants pondérés (8) est reliée audit circuit charge-pompe (3) de manière à commuter directement les courants sur un émetteur d'un ou de plusieurs transistors du circuit charge-pompe et **en ce que** la source de courants pondérés est commandée par un signal généré par le générateur de fenêtre temporelle pendant une durée $\Delta$Tcor.

**2.** Synthétiseur de fréquence selon la revendication 1 **caractérisé en ce qu'**il est alimenté sous une faible tension tension sensiblement égale à 2,7 V.

**3.** Syntnétiseur selon la revendication 2 **caractérisé en ce que** la source de tension est unique.

**4.** Synthétiseur selon l'une des revendications 1 à 3 caractèrisé en ce que les courants sont commutés pendant une durée sensiblement égale à un multiple d'une fenêtre temporelle de correction générée par le générateur de fenêtre temporelle (9) et en fonction d'une valeur du contenu de l'accumulateur de phase.

**5.** Synthétiseur selon l'une des revendications 1 à 4 **caractérisé en ce que** le circuit charge-pompe (3) comporte au moins :

- un transistor (Q3) ayant un émetteur (38) relié à une résistance Rc en liaison elle-même au comparateur de phase (2),
- un transistor (Q2) dans lequel circule un courant de charge Ic, en liaison avec le circuit d'intégration (4), et
- un transistor (Q4) ayant un émetteur (41) relié à une résistance Rp reliée au comparateur de phase (2) et un collecteur relié au circuit d'intégration (4) un courant Ip de décharge circulant à travers la résistance Rp et le transistor Q4,

et **en ce que** la source de courant de poids pondérés (8) comporte une ou plusieurs résistances R1, R2, R3 disposées en parallèle, la ou lesdites résistances étant reliées à l'émetteur (38) du transistor Q3 et à au moins un transistor à effet de champ Q5, Q6, Q7 recevant au niveau de chacune de leur grille (48, 45, 42) une ou les valeurs de Pk contenues dans l'accumulateur de phase (71), la source (50, 47, 44) des transistors à effet de champ étant en liaison avec le générateur de fenêtre temporelle (9) de correction générant pendant un temps de correction Tcor un niveau bas ou « 0V »

**6.** Synthétiseur selon la revendication 5 **caractérisé en ce que** le circuit de génération de courants comporte trois résistances R1, R2 et R3 disposées en parallèle telles que R3=R, R2=2R et R1=4R.

**7.** Synthétiseur selon la revendication 6 **caractérisé en ce que** Tcor=n/Fs et

$$Icor = \frac{Ip}{n * M}$$

**8.** Synthétiseur de fréquence selon l'une des revendications 1 à 4 **caractérisé en que** le circuit charge-pompe (3) comporte au moins

- un transistor (Q3) dont l'émetteur (38) est relié à une résistance Rc en liaison elle-même avec le comparateur de phase (2),
- un transistor (Q2) dans lequel circule le courant de charge Ic en liaison avec le circuit d'intégration (41), et
- un transistor (Q4) dont l'émetteur (41) est rélié à une résistance Rp en liaison avec le comparateur de phase et le collecteur en liaison avec le circuit d'intégration, le courant Ip de décharge circulant à travers Rp et Q4, et un transistor (Q5) dont la base (51) est reliée à la base (36) de l'émetteur (Q3), le collecteur (52) relié à la base (30) de Q1 et l'émetteur (53) est relié à une résistance Rcor, la résistance Rcor étant reliée à dispositif (9) générant un signal de niveau bas « 0V » pendant une durée de correction Tcor.

**9.** Synthétiseur selon la revendication 8 **caractérisé en ce que** la durée Tcor est égale à (Pk+1)*n/Fs.

**10.** Synthétiseur de fréquence à temps d'acquisition rapide et à faible bruit de phase à division fractionnaire selon l'une des revendications 1 à 9,

**11.** Dispositif de radiocommunication comportant au moins un émetteur et un récepteur et un synthétiseur de fréquence à division fractionnaire selon l'une des revendications 1 à 10.

**12.** Procédé pour synthétiser une fréquence comprenant l'utilisation d'une boucle de synthèse en fréquence comportant un diviseur programmable (1) à rang variable N, un oscillateur commandé en tension (6), un circuit charge-pompe (3) comprenant plusieurs transistors, un circuit d'intégration et de filtre (4), une source de courants pondérés (8), un accumulateur de phase (7) et un générateur de fenêtre temporelle **caractérisé en ce qu'**il comporte au moins les étapes suivantes :

- coupler une sortie de la source de courants pondérés (8) au circuit de charge-pompe (3) afin de commuter directement un ou plusieurs courants de correction sur un émetteur d'au moins un des transistors du circuit de charge-pompe, et
- générer un signal à partir du générateur de fenêtre temporelle (9) de niveau bas « 0 » et appliquer ce signal à la source de courants pondérés pendant une durée $\Delta$Tcor.

**13.** Procédé selon la revendication 12 **caractérisé en ce que** la durée $Tcor = \dfrac{n}{F_s}$ et $Icor = \dfrac{I_p}{n * M}$ n étant une caractéristique du compteur de la fenêtre temporelle.

**14.** Procédé selon la revendication 12 **caractérisé en ce que** $Tcor = \dfrac{(P_k + 1)}{n * F_s}$.

**15.** Procédé selon l'une des revendications 12 à 14 **caractérisé en ce que** l'on utilise une alimentation faible tension sensiblement égale à 2,7 V.

**16.** Application du synthétiseur selon l'une des revendications 1 à 10 et du procédé selon l'une des revendications 12 à 15 à la synthèse de fréquence pour des applications de type GSM et/ou GPRS.

**Patentansprüche**

**1.** Frequenzsynthesizer mit multipler nichtganzzahliger Teilung, der einen Frequenzgenerator (5), einen spannungsgesteuerten Oszillator (6), einen programmierbaren Divisor (1) mit variablem Rang N, einen Phasenkomparator (2), eine Integrations- und Filterschaltung (4), einen Zeitfenstergenerator (9), eine Quelle gewichteter Ströme (8), einen Phasenakkumulator (7), eine Lade-Pump-Schaltung (3) mit mehreren Transistoren (Qi) aufweist, **dadurch gekennzeichnet, dass** die Quelle gewichteter Ströme (8) derart mit der Lade-Pump-Schaltung (3) verbunden ist, dass die Ströme direkt auf einen Emitter eines oder mehrerer Transistoren der Lade-Pump-Schaltung umgeschaltet werden, und dass die Quelle gewichteter Ströme von einem Signal gesteuert wird, das vom Zeitfenstergenerator während einer Dauer $\Delta$Tcor erzeugt wird.

**2.** Frequenzsynthesizer nach Anspruch 1, **dadurch gekennzeichnet, dass** er mit einer geringen Spannung von im Wesentlichen gleich 2,7 V gespeist wird.

**3.** Synthesizer nach Anspruch 2, **dadurch gekennzeichnet, dass** es nur eine Spannungsquelle gibt.

**4.** Synthesizer nach einem der Ansprüche 1 bis 3, **dadurch gekennzeichnet, dass** die Ströme während einer Dauer umgeschaltet werden, die im Wesentlichen gleich einem Vielfachen eines Korrekturzeitfensters ist, das vom Zeitfenstergenerator (9) erzeugt wird, und in Abhängigkeit von einem Wert des Inhalts des Phasenakkumulators.

**5.** Synthesizer nach einem der Ansprüche 1 bis 4, **dadurch gekennzeichnet, dass** die Lade-Pump-Schaltung (3) mindestens aufweist:

- einen Transistor (Q3) mit einem Emitter (38), der mit einem Widerstand Rc verbunden ist, der selbst mit dem Phasenkomparator (2) in Verbindung steht,
- einen Transistor (Q2), in dem ein Ladestrom Ic fließt, in Verbindung mit der Integrationsschaltung (4), und
- einen Transistor (Q4) mit einem Emitter (41), der mit einem Widerstand Rp verbunden ist, der mit dem Phasenkomparator (2) verbunden ist, und mit einem Kollektor, der mit der Integrationsschaltung (4) verbunden ist, wobei ein Entladestrom Ip durch den Widerstand Rp und den Transistor Q4 fließt,

und dass die Quelle gewichteter Ströme (8) einen oder mehrere parallelgeschaltete Widerstände R1, R2, R3 aufweist, wobei der oder die Widerstände mit dem Emitter (38) des Transistors Q3 und mit mindestens einem Feldeffekttransistor Q5, Q6, Q7 verbunden sind, die in Höhe jedes ihrer Gates (48, 45, 42) einen oder die Werte von Pk empfangen, die im Phasenakkumulator (71) enthalten sind, wobei die Source (50, 47, 44) der Feldeffekttransistoren mit dem Korrekturzeitfenstergenerator (9) in Verbindung steht, der während einer Korrekturzeit Tcor einen niedrigen Pegel oder "0 V" erzeugt.

6. Synthesizer nach Anspruch 5, **dadurch gekennzeichnet, dass** die Stromerzeugungsschaltung drei Widerstände R1, R2 und R3 aufweist, die so parallelgeschaltet sind, dass R3=R, R2=2R und R1=4R ist.

7. Synthesizer nach Anspruch 6, **dadurch gekennzeichnet, dass** Tcor=n/Fs und $Icor = \dfrac{Ip}{n*M}$ ist.

8. Frequenzsynthesizer nach einem der Ansprüche 1 bis 4, **dadurch gekennzeichnet, dass** die Lade-Pump-Schaltung (3) mindestens aufweist

   · einen Transistor (Q3), dessen Emitter (38) mit einem Widerstand Rc verbunden ist, der selbst mit dem Phasenkomparator (2) in Verbindung steht,
   · einen Transistor (Q2), in dem der Ladestrom Ic fließt, in Verbindung mit der Integrationsschaltung (41), und
   · einen Transistor (Q4), dessen Emitter (41) mit einem Widerstand Rp verbunden ist, der mit dem Phasenkomparator in Verbindung steht, und der Kollektor mit der Integrationsschaltung in Verbindung steht, wobei der Entladestrom Ip durch Rp und Q4 fließt, und einen Transistor (Q5,) dessen Basis (51) mit der Basis (36) des Emitters (Q3) verbunden ist, der Kollektor (52) mit der Basis (30) von Q1, und der Emitter (53) mit einem Widerstand Rcor verbunden ist, wobei der Widerstand Rcor mit der Vorrichtung (9) verbunden ist, die ein Signal mit niedrigem Pegel "0 V" während einer Korrekturdauer Tcor erzeugt.

9. Synthesizer nach Anspruch 8, **dadurch gekennzeichnet, dass** die Dauer Tcor gleich (Pk+1)*n/Fs ist.

10. Frequenzsynthesizer mit schneller Erfassungszeit und geringem Phasenrauschen mit nichtganzzahliger Teilung nach einem der Ansprüche 1 bis 9.

11. Funkverkehrvorrichtung, die mindestens einen Sender und einen Empfänger und einen Frequenzsynthesizer mit nichtganzzahliger Teilung nach einem der Ansprüche 1 bis 10 aufweist.

12. Verfahren zum Synthetisieren einer Frequenz, das die Verwendung einer Frequenzsyntheseschleife enthält, die einen programmierbaren Divisor (1) mit variablem Rang N, einen spannungsgesteuerten Oszillator (6), eine Lade-Pump-Schaltung (3) mit mehreren Transistoren, eine Integrations- und Filterschaltung (4), eine Quelle gewichteter Ströme (8), einen Phasenakkumulator (7) und einen Zeitfenstergenerator aufweist, **dadurch gekennzeichnet, dass** es mindestens die folgenden Schritte aufweist:

   · Koppeln eines Ausgangs der Quelle gewichteter Ströme (8) an die Lade-Pump-Schaltung (3), um direkt einen oder mehrere Korrekturströme auf einen Emitter mindestens eines der Transistoren der Lade-Pump-Schaltung umzuschalten, und
   · Erzeugen eines Signals ausgehend vom Zeitfenstergenerator (9) mit niedrigem Pegel "0 V" und Anlegen dieses Signals an die Quelle gewichteter Ströme während einer Dauer ∆Tcor.

13. Verfahren nach Anspruch 12, **dadurch gekennzeichnet, dass** die Dauer $Tcor = \dfrac{n}{F_i}$ und $Icor = \dfrac{I_P}{n*M}$, wobei n eine Charakteristik des Zählers des Zeitfensters ist.

14. Verfahren nach Anspruch 12, **dadurch gekennzeichnet, dass** $Tcor = \dfrac{(P_k + 1)}{n*F_i}$ ist.

15. Verfahren nach einem der Ansprüche 12 bis 14, **dadurch gekennzeichnet, dass** man eine Niederspannungsversorgung von im Wesentlichen gleich 2,7 V verwendet.

16. Anwendung des Synthesizers nach einem der Ansprüche 1 bis 10 und des Verfahrens nach einem der Ansprüche 12 bis 15 auf die Frequenzsynthetisierung für Anwendungen vom Typ GSM und/oder GPRS.

**Claims**

1. Frequency synthesizer using multiple fractional division comprising a frequency generator (5), a voltage-controlled oscillator (6), a programmable divider (1) of variable rank N, a phase comparator (2), an integration and filter circuit (4), a time window generator (9), a weighted current source (8), a phase accumulator (7), a charge-pump circuit (3) comprising several transistors (Qi), **characterized in that** the said weighted current source (8) is connected to the said charge-pump circuit (3) so as to directly switch the currents onto an emitter of one or more transistors of the charge-pump circuit and **in that** the weighted current source is controlled by a signal generated by the time window generator for a time period $\Delta$Tcor.

2. Frequency synthesizer according to Claim 1, **characterized in that** it is powered by a low voltage substantially equal to 2.7 V.

3. Synthesizer according to Claim 2, **characterized in that** this is the only voltage source.

4. Synthesizer according to one of Claims 1 to 3, **characterized in that** the currents are switched for a time period substantially equal to a multiple of a correction time window generated by the time window generator (9) and which is a function of a value of the contents of the phase accumulator.

5. Synthesizer according to one of Claims 1 to 4, **characterized in that** the charge-pump circuit (3) comprises at least:

   • one transistor (Q3) having an emitter (38) connected to a resistor Rc that is itself connected to the phase comparator (2),

   • one transistor (Q2), through which a charge current Ic flows, connected to the integration circuit (4), and

   • one transistor (Q4) having an emitter (41) connected to a resistor Rp that is connected to the phase comparator (2) and a collector connected to the integration circuit (4), a discharge current Ip flowing through the resistor Rp and the transistor Q4,

   and **in that** the weighted-intensity current source (8) comprises one or more resistors R1, R2, R3 arranged in parallel, the said resistor or resistors being connected to the emitter (38) of the transistor Q3 and to at least one field-effect transistor Q5, Q6, Q7 receiving at each of their gates (48, 45, 42) one or more values of Pk contained in the phase accumulator (71), the source (50, 47, 44) of the field-effect transistors being connected to the correction time window generator (9) generating a low level or '0 V' for a correction time period Tcor.

6. Synthesizer according to Claim 5, **characterized in that** the current generation circuit comprises three resistors R1, R2 and R3 arranged in parallel such that R3 = R, R2 = 2R and R1 = 4R.

7. Synthesizer according to Claim 6, **characterized in that** Tcor = n/Fs and Icor = $\frac{Ip}{n*M}$ .

8. Frequency synthesizer according to one of Claims 1 to 4, **characterized in that** the charge-pump circuit (3) comprises at least:

   • one transistor (Q3) whose emitter (38) is connected to a resistor Rc that is itself connected to the phase comparator (2),

   • one transistor (Q2), through which the charge current Ic flows, connected to the integration circuit (41), and

   • one transistor (Q4) whose emitter (41) is connected to a resistor Rp that is connected to the phase comparator and whose collector is connected to the integration circuit, the discharge current Ip flowing through Rp and Q4, and one transistor (Q5) whose base (51) is connected to the base (36) of the emitter (Q3), whose collector (52) is connected to the base (30) of Q1 and whose emitter (53) is connected to a resistor Rcor, the resistor Rcor being connected to a device (9) generating a low-level '0 V' signal for a correction time period Tcor.

9. Synthesizer according to Claim 8, **characterized in that** the time period Tcor is equal to (Pk+1)*n/Fs.

10. Frequency synthesizer with high-speed acquisition and low phase noise using fractional division according to one of Claims 1 to 9.

11. Wireless communication device comprising at least one transmitter and one receiver and one frequency synthesizer using fractional division according to one of Claims 1 to 10.

12. Process for synthesizing a frequency comprising the use of a frequency-synthesis loop comprising a programmable divider (1) of variable rank N, a voltage-controlled oscillator (6), a charge-pump circuit (3) comprising several transistors, an integration and filter circuit (4), a weighted current source (8), a phase accumulator (7) and a time window generator, **characterized in that** it comprises at least the following steps:

   • coupling an output of the weighted current source (8) to the charge-pump circuit (3) in order to directly switch one or more correction currents onto an emitter of at least one of the transistors of the charge-pump circuit, and

   • generating a low-level '0 V' signal from the time window generator (9) and applying this signal to the weighted current source for a time period $\Delta$Tcor.

13. Process according to Claim 12, **characterized in that** the time period $Tcor = \dfrac{n}{F_s}$ and $Icor = \dfrac{Ip}{n*M}$ , n being a characteristic of the time window counter.

14. Process according to Claim 12, **characterized in that** $Tcor = \dfrac{(P_k + 1)}{n*F_s}$.

15. Process according to one of Claims 12 to 14, **characterized in that** a low-voltage power supply, substantially equal to 2.7 V, is used.

16. Application of the synthesizer according to one of Claims 1 to 10 and of the process according to one of Claims 12 to 15 to frequency synthesis for applications of the GSM and/or GPRS type.

**FIG.1**

- 4 — CIRCUIT D'INTÉGRATION ET DE FILTRAGE
- 6 — VCO
- $F_s$
- 3 — CHARGE POMPE
- 2 — COMPARATEUR PHASE FRÉQUENCE
- 8 — SOURCE DE COURANTS PONDÉRÉS
- 9 — GÉNÉRATEUR DE FENÊTRE TEMPORELLE DE CORRECTION
- 5 — GÉNÉRATEUR D'UNE FRÉQUENCE $F_r$ DE RÉFÉRENCE
- 1 — DIVISEUR À RANG VARIABLE N
- COMMANDE N+1
- 7 — ACCUMULATEUR DE PHASE MODULO M
- $P_k$
- N
- F

FIG. 2

$$V_{alim} \quad +2,7 \text{ V}$$

$$I_c = I_0 + I_{cor} = (V_{réf} - 0,6)\left[\frac{1}{R_c} + \left(\frac{1}{R} + \frac{1}{2R} + \frac{1}{4R}\right)\right]$$

Q1 30  31  32  33  Q2 34  35

INTÉGRATEUR → VERS VCO  4

$V_{réf}$

Q3 37 36  40  Q4  39  41

$$I_p = \frac{V_{réf} - 0,6}{R_p}$$

38

R  2R  4R  $R_c$  $R_p$

$\downarrow I_{c3}$  $\downarrow I_{c2}$  $\downarrow I_{c1}$

20  2,7 V / 0V  21  2,7 V / 0V

VOIE RETARD DE PHASE  VOIE AVANCE DE PHASE

49  $Q_5$ 48  46  $Q_6$ 45  43  $Q_7$ 42
50  47  44
$PK_3$  $PK_2$  $PK_1$

9

$F_s$

$$T_{cor} = \frac{n}{F_s}$$  2,7 V / 0V

FIG.3

EP 1 146 647 B1

$+2{,}7\,V$

$V_{alim}$

$Q_1$ 30

$Q_2$

$$I_c = I_o + I_{cor} = (V_{réf} - 0{,}6)\left(\frac{1}{R_c} + \frac{1}{R_{cor}}\right)$$

VERS VCO

4

$Q_3$ 36

$V_{réf}$

$Q_4$

$$I_p = \frac{V_{réf} - 0{,}6}{R_p}$$

52

$Q_5$

53

51

$R_{cor}$

$R_c$

$R_p$

$I_{cor}$

20

$\begin{cases} 2{,}7\,V \\ 0\,V \end{cases}$

21

$\begin{cases} 2{,}7\,V \\ 0\,V \end{cases}$

VOIE RETARD
DE PHASE

VOIE AVANCE
DE PHASE

$\dfrac{F_s}{n}$

9

$2^0$ $2^1$ $2^2$

58

57

$\begin{cases} 2{,}7\,V \\ 0\,V \end{cases}$

$$T_{cor} = \frac{(P_K + 1)n}{F_s}$$

+

"1"

56

55

$PK_1$ $PK_2$ $PK_3$

54

7

FIG.4